(19) Europäisches Patentamt
European Patent Office
Office européen des brevets

(11) **EP 4 592 695 A1**

(12) **EUROPEAN PATENT APPLICATION**
published in accordance with Art. 153(4) EPC

(43) Date of publication:
30.07.2025 Bulletin 2025/31

(21) Application number: 23867780.1

(22) Date of filing: 22.02.2023

(51) International Patent Classification (IPC):
*G01R 31/392* (2019.01)  *G01R 31/367* (2019.01)
*G01R 31/382* (2019.01)  *G01R 31/385* (2019.01)
*H01M 10/48* (2006.01)  *H02J 7/00* (2006.01)

(52) Cooperative Patent Classification (CPC):
G01R 31/367; G01R 31/382; G01R 31/385;
G01R 31/392; H01M 10/48; H02J 7/00

(86) International application number:
PCT/JP2023/006376

(87) International publication number:
WO 2024/062648 (28.03.2024 Gazette 2024/13)

(84) Designated Contracting States:
AL AT BE BG CH CY CZ DE DK EE ES FI FR GB
GR HR HU IE IS IT LI LT LU LV MC ME MK MT NL
NO PL PT RO RS SE SI SK SM TR
Designated Extension States:
BA
Designated Validation States:
KH MA MD TN

(30) Priority: 22.09.2022 JP 2022151074

(71) Applicant: **Hitachi, Ltd.**
**Tokyo 100-8280 (JP)**

(72) Inventor: **HONKURA, Kohei**
**Tokyo 100-8280 (JP)**

(74) Representative: **MERH-IP Matias Erny Reichl**
**Hoffmann**
**Patentanwälte PartG mbB**
**Paul-Heyse-Straße 29**
**80336 München (DE)**

(54) **DEGRADATION PREDICTION DEVICE FOR SECONDARY BATTERY AND DEGRADATION PREDICTION METHOD FOR SECONDARY BATTERY**

(57) To easily acquire deterioration states of a secondary battery. To do this, a degradation prediction device for secondary battery (1) includes a reference degradation characteristic calculation portion (10) to output a reference degradation characteristic (DC) in terms of a first battery (110); a correction coefficient calculation portion (20) to calculate a correction coefficient ($\alpha$) based on a first reference degradation characteristic (DC1) acquired by supplying the reference degradation characteristic calculation portion (10) with a first use condition information (US1) as one piece of use condition information (US) and based on at least one piece of degradation point data (DA1) when a second battery (120) is used under a use condition specified in the first use condition information (US1); and a degradation characteristic correction portion (30) to output estimated degradation characteristic data (DP2) based on a second reference degradation characteristic (DC2) and a correction coefficient ($\alpha$).

FIG. 1

## Description

Technical Field

The present invention relates to a degradation prediction device for a secondary battery and a degradation prediction method for a secondary battery.

Background Art

As background art of this technical field, the following patent literatures 1 through 3 describe techniques of diagnosing secondary battery degradation, for example. The descriptions in these literatures are included as part of the present specification.

Citation List

Patent Literature

> Patent Literature 1: Japanese Unexamined Patent Application Publication No. 2022-018264
> Patent Literature 2: Japanese Unexamined Patent Application Publication No. 2009-080093
> Patent Literature 3: International Publication WO No. 2014/128902

Summary of Invention

Technical Problem

The above-described techniques demand to more easily acquire the secondary battery degradation states.

The present invention has been made in consideration of the foregoing and aims to provide a degradation prediction device for a secondary battery and a degradation prediction method for secondary battery capable of easily acquiring degradation states of a secondary battery.

Solution to Problem

To solve the above-mentioned problem, a degradation prediction device for secondary battery according to the present invention includes a reference degradation characteristic calculation portion that outputs a reference degradation characteristic as relationship between a usage amount and a degradation level, corresponding to the input use condition information in terms of a first battery; a correction coefficient calculation portion that calculates a correction coefficient based on a first reference degradation characteristic acquired by supplying the reference degradation characteristic calculation portion with first use condition information as one piece of the use condition information, and based on at least one piece of degradation point data as a combination of the usage amount and the degradation level when a second battery is used under a use condition specified in the first use condition information; and a degradation characteristic correction portion that outputs estimated degradation characteristic data as a result of estimating the relationship between the usage amount and the degradation level of the second battery under a use condition specified in the second use condition information, based on a second reference degradation characteristic acquired by supplying the reference degradation characteristic calculation portion with a second use condition information as the use condition information different from the first use condition information and based on the correction coefficient.

Advantageous Effects of Invention

The present invention can easily acquire degradation states of a secondary battery.

Brief Description of Drawings

> FIG. 1 is a block diagram illustrating a degradation prediction device according to a first embodiment.
> FIG. 2 is a diagram illustrating various degradation characteristics.
> FIG. 3 is a block diagram of a computer.
> FIG. 4 is a flowchart of a degradation prediction routine executed by the degradation prediction device.
> FIG. 5 is a diagram illustrating another example of various degradation characteristics.
> FIG. 6 is a block diagram illustrating the degradation prediction device according to a third embodiment.
> FIG. 7 is a block diagram illustrating the degradation prediction device according to a fourth embodiment.
> FIG. 8 is a flowchart illustrating the main part of operations on the degradation prediction device according to the fourth embodiment.

Description of Embodiments

Overview of the Embodiments

Secondary batteries such as lithium-ion batteries are used as driving power supplies installed in vehicles and electricity storage power supplies for smart houses and other consumer and industrial applications to improve the energy efficiency of devices. It is known that the battery characteristics of lithium-ion batteries degrade when they are repeatedly charged and discharged or stored in a high-temperature environment. In recent years, attention has been paid to the secondary use of used batteries for other purposes such as electric vehicle applications. In recent years, technologies to predict battery characteristic degradation have been researched and developed. A general technique of predicting characteristic degradation involves using a battery under various use conditions, measuring the relationship between the period of use and the characteristics, and generating a degradation model representing the relationship between the use condition and the characteristic degradation. Any use condition can be input to the degradation model and the predicted result of characteristic degradation can be output. However, long-term life tests are required to generate a highly reliable degradation model for batteries.

It is believed that the use of the technology described in the above-described patent literature 1 can predict battery degradation. Through the use of the technology described in patent literature 1, a battery degradation model is constructed based on a life test, operation data and degradation level of the same battery are acquired after the test, and the degradation model can be adjusted so that the degradation level calculated by inputting the operation data to the degradation model approaches the acquired degradation level. This method is believed to be able to shorten the life test period for constructing a battery degradation model.

However, the technology based on the patent literature 1 requires preparing a battery and an experimental facility and conducting a life test for a certain period. Battery users who do not have batteries or battery experimental facilities are forced to estimate the battery life under complex use conditions based on limited degradation data provided by battery suppliers. In cases where the secondary use of batteries handles batteries of various specifications, degradation models are hardly available for all specifications of batteries, and in such cases, the conventional technology cannot be used. The embodiments described below aim to predict characteristic degradation even when a battery life test is not performed.

First Embodiment

<Configuration of First Embodiment>

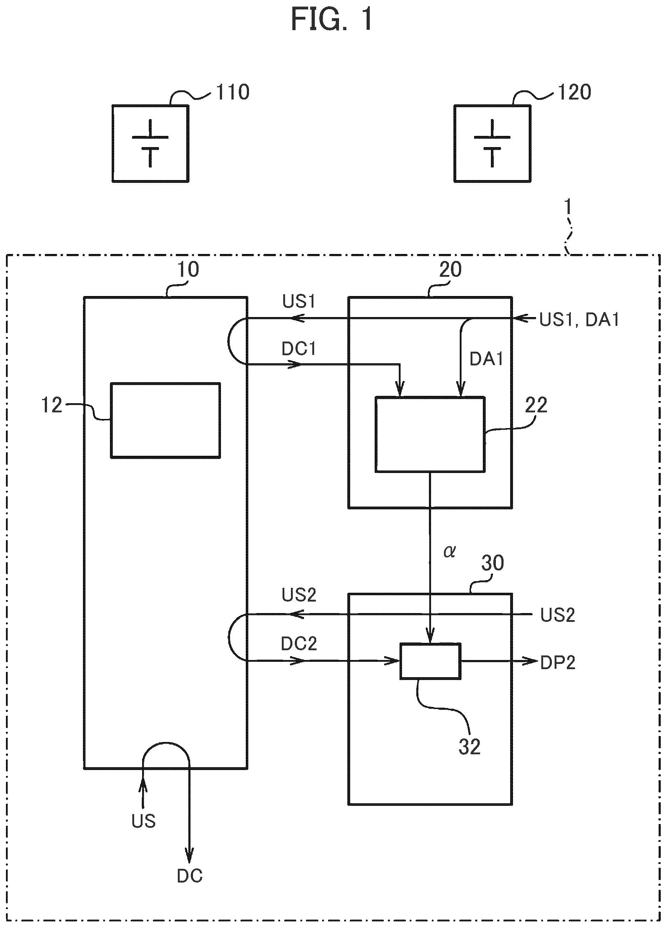

FIG. 1 is a block diagram illustrating a degradation prediction device 1 according to a first embodiment.

As illustrated in FIG. 1, the degradation prediction device 1 includes a degradation characteristic calculation portion 10 (reference degradation characteristic calculation portion), a correction coefficient calculation portion 20, and a degradation characteristic correction portion 30. The present embodiment assumes two types of secondary batteries 110 and 120. The secondary battery 110 (first battery) uses known types of positive-electrode active material and negative-electrode active material so that various characteristics are completely analyzed in detail. The secondary battery 120 (second battery) is not yet ready for detailed analysis of the characteristics, for example No characteristic degradation model is defined for the secondary battery 120. The secondary battery 120 favorably uses electrode active materials such as positive-electrode and negative-electrode active materials which are the same type as or similar to the secondary battery 110.

The degradation characteristic calculation portion 10 stores a characteristic degradation model 12. The characteristic degradation model 12 defines a method of calculating degradation states of the secondary battery 110 and provides a set of equations and parameters, for example, to calculate degradation characteristic data DC (reference degradation characteristic). The degradation characteristic data DC represents the relationship between the "usage amount" and the "degradation level" of the secondary battery and is preferably available as a data table that associates the usage amount with the degradation level.

The "usage amount" in the degradation characteristic data DC represents the degree of using the secondary battery. For example, the "usage amount" can be applied to "usage time," "amount of electricity charged or discharged," or "value supplemented with the result of weighting the usage time and the amount of electricity charged or discharged."

The "degradation level" in the degradation characteristic data DC is an amount representing the degree of degradation of the secondary battery or the degree of change in the characteristics. For example, the "degradation level" can be applied to the "capacity retention rate," "ratio of internal resistance to the initial state," and "ratio of impedance to the initial state" of the secondary battery. It is more favorable that the degradation characteristic data DC includes information such as the positive electrode capacity and the negative electrode capacity of the secondary battery, the range of using the positive electrode corresponding to the SOC range, the range of using the negative electrode corresponding to the SOC range, the internal resistance at the positive electrode side, the internal resistance at the negative electrode side, the resistance of the electrolyte, and the resistance of a current collector.

The degradation characteristic calculation portion 10 is supplied with use condition information US and then outputs degradation characteristic data DC corresponding to the use condition information US. The use condition information US may represent the "battery temperature," "ambient temperature," "SOC (State of Charge)," "charge/discharge current," "SOC range in charge/discharge cycle," "repetitive pattern of storage and charge/discharge cycle" of the secondary battery or a combination of these, for example.

More specifically, the use condition information US may include the following:

(1) Storage period at a battery temperature of 40°C and 70% SOC
(2) Charge/discharge current amount at the ambient temperature of 25°C and a specified hour rate of charge/discharge current

(3) SOC range: charge/discharge cycle of 20% through 80%

(4) Frequency of repetition of storage and charge/-discharge cycle

The use condition information US should fall within a range recommended for both the secondary batteries 110 and 120.

The correction coefficient calculation portion 20 acquires use condition information US1 (first use condition information) and one or more pieces of degradation point data DA1 concerning the secondary battery 120. For example, the user may manually input these based on the measurement results. The "degradation point data" combines one usage amount of the secondary battery and one corresponding degradation level.

The correction coefficient calculation portion 20 supplies the use condition information US1 to the degradation characteristic calculation portion 10 and thereby acquires degradation characteristic data DC1 (first reference degradation characteristic) corresponding to the use condition information US1. Therefore, the degradation characteristic data DC1 indicates the degradation characteristics supposed to be found in the secondary battery 110 when the secondary battery 110 is used based on the use condition information US1 as the use condition of the secondary battery 120.

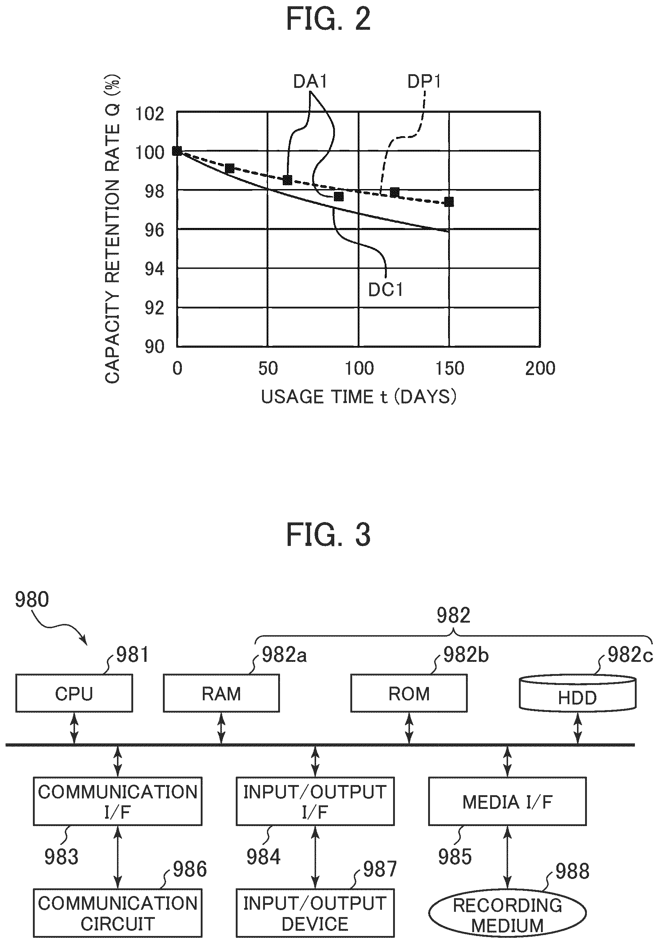

FIG. 2 is a diagram illustrating various degradation characteristics. FIG. 2 illustrates the relationship among the degradation characteristic data DC1, the degradation point data DA1, and the estimated degradation characteristic data DP1.

In FIG. 2, the horizontal axis represents usage time t (usage amount) in units of "days," and the vertical axis represents capacity retention rate Q (degradation level) in units of "%".

In the illustrated example, the degradation characteristic data DC1 provides the degradation characteristic of the secondary battery 110 (see FIG. 1), indicating that the capacity retention rate Q decreases with the advance of the usage time t.

The degradation characteristic data DC1 in FIG. 2 applies to the secondary battery 110 including a ternary positive electrode (primarily composed of nickel, manganese, and cobalt) and a graphite negative electrode. The use condition information US1 (see FIG. 1) is based on "ambient temperature of 25°C and 75% SOC during storage." In other words, the degradation characteristic data DC1 in FIG. 2 represents the capacity retention rate when the secondary battery 110 is stored at an ambient temperature of 25°C and 75% SOC.

The degradation point data DA1 shown in black rectangles in FIG. 2 is measured on the secondary battery 120 based on the use condition information US1 described above. The secondary battery 120 in the illustrated example uses the ternary positive electrode and the graphite negative electrode similar to the secondary battery 110. The degradation point data DA1 in FIG. 2 results from storing the secondary battery 120 at an ambient temperature of 25°C and 75% SOC and measuring the capacity retention rate six times.

The estimated degradation characteristic data DP1 illustrated in FIG. 2 is calculated based on equation (1) below.

$$DP1(t) = 1 - \alpha(1 - DC1(t)) \quad \cdots \quad (1)$$

Correction coefficient $\alpha$ in equation (1) is determined to minimize the sum of square errors of degradation point data DA1 referring to estimated degradation characteristic data DP1. In the example of FIG. 2, the correction coefficient $\alpha$ is "0.652".

Returning to FIG. 1, an arithmetic portion 22 included in the correction coefficient calculation portion 20 calculates correction coefficient $\alpha$ based on degradation characteristic data DC1 and degradation point data DA1.

However, various methods to calculate correction coefficient $\alpha$ are available in addition to the method described by reference to FIG. 2. For example, degradation characteristic data DC1 and degradation point data DA1 may be regressed to appropriate functions such as linear functions or power functions, and the coefficient ratio between both in the regression results may be used as correction coefficient $\alpha$.

The degradation characteristic correction portion 30 acquires use condition information US2 (second use condition information) different from the use condition information US1 described above in terms of the secondary battery 120 and supplies the use condition information US2 to the degradation characteristic calculation portion 10. The user may also manually input this use condition information US2, for example. Therefore, the degradation characteristic correction portion 30 acquires degradation characteristic data DC2 (second reference degradation characteristic) from the degradation characteristic calculation portion 10. The degradation characteristic data DC2 indicates the degradation characteristics supposed to be found in the secondary battery 110 when the secondary battery 110 is used based on the use condition information US2.

An arithmetic portion 32 included in the degradation characteristic correction portion 30 calculates estimated degradation characteristic data DP2 corresponding to the use condition information US2 based on equation (2) below.

$$DP2(t) = 1 - \alpha(1 - DC2(t)) \quad \cdots \quad (2)$$

It is possible to easily acquire the corresponding estimated degradation characteristic data DP2 in terms of the use condition information US2 corresponding to various use conditions of the secondary battery 120, even in a situation where detailed analysis results cannot be acquired from the secondary battery 120 itself.

FIG. 3 is a block diagram of a computer 980.

The degradation prediction device 1 illustrated in FIG. 1 and the degradation prediction devices in other embodiments described later include one or more computers 980 illustrated in FIG. 3.

In FIG. 3, the computer 980 includes a CPU 981, a storage portion 982, a communication I/F (interface) 983, an input/output I/F 984, and a media I/F 985. The storage portion 982 includes RAM 982a, ROM 982b, and HDD 982c.

The communication I/F 983 is connected to a communication circuit 986. The input/output I/F 984 is connected to an input/output device 987. The media I/F 985 reads and writes data from a recording medium 988. The ROM 982b stores an IPL (Initial Program Loader) executed by the CPU, for example. The HDD 982c stores application programs and various data, for example. The CPU 981 provides various functions by executing application programs loaded from the HDD 982c to the RAM 982a. In FIG. 1 above, the inside of the degradation prediction device 1 includes a block diagram illustrating the functions implemented by application programs.

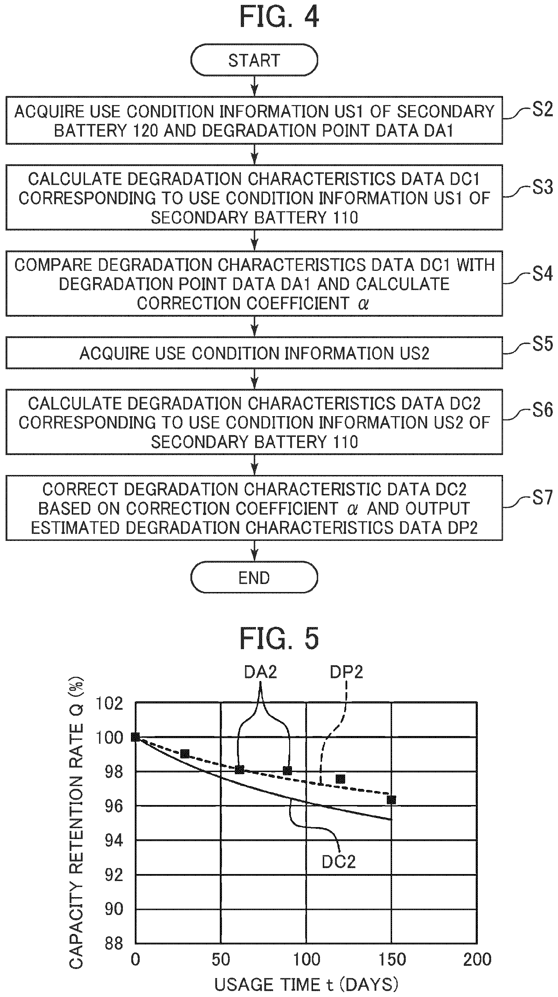

FIG. 4 is a flowchart of a degradation prediction routine executed by the degradation prediction device 1.

In FIG. 4, when the process proceeds to step S2, the correction coefficient calculation portion 20 acquires the use condition information US1 defining the use conditions of the secondary battery 120 and one or more pieces of degradation point data DA1 in the use conditions. When the process proceeds to step S3, the degradation characteristic calculation portion 10 uses the characteristic degradation model 12 to calculate the degradation characteristic data DC1 corresponding to the use condition information US1 of the secondary battery 110.

When the process proceeds to step S4, the correction coefficient calculation portion 20 compares the degradation characteristic data DC1 with the degradation point data DA1 and calculates correction coefficient $\alpha$.

When the process proceeds to step S5, the degradation characteristic correction portion 30 acquires the use condition information US2 different from the use condition information US1.

When the process proceeds to step S6, the degradation characteristic calculation portion 10 calculates the degradation characteristic data DC2 of the secondary battery 110 corresponding to the use condition information US2.

When the process proceeds to step S7, the degradation characteristic correction portion 30 corrects the degradation characteristic data DC2 based on the correction coefficient $\alpha$ and outputs the result as the estimated degradation characteristic data DP2.

FIG. 5 is a diagram illustrating another example of various degradation characteristics. FIG. 5 illustrates the relationship among the degradation characteristic data DC2 and the estimated degradation characteristic data DP2.

The illustrated degradation characteristic data DC2 is calculated by the degradation characteristic calculation portion 10 based on the use condition information US2 (see FIG. 1) different from the use condition information US1 described above. Specifically, the use condition information US2 designates "ambient temperature of 40°C and 50% SOC during storage." FIG. 5 also illustrates the degradation point data DA2 as the result of practically measuring the capacity retention rate Q of the secondary battery 120. The degradation point data DA2 is not used in the above-described process and is presented as a reference. The example in FIG. 5 can clarify that the estimated degradation characteristic data DP2 causes a predicted error significantly smaller than a predicted error of the degradation point data DA2 in the degradation characteristic data DC2.

Second Embodiment

The description below explains the second embodiment.

In the following description, parts corresponding to those in the first embodiment described above are given the same reference numerals and the corresponding description may be omitted.

The degradation prediction device 1 according to the second embodiment uses a configuration similar to that in the first embodiment (see FIG. 1). However, the use condition information US includes storage-based use condition information USK (first-class use condition information, unshown) when the secondary battery is stored (when no charge/discharge current flows); and charge/discharge-based use condition information USE (second-class use condition information, unshown) when the secondary battery is charged or discharged.

The characteristic degradation model 12 includes a storage-based characteristic degradation model 12K (unshown) when the secondary battery is stored; and a charge/discharge-based characteristic degradation model 12E (unshown) when the secondary battery is charged or discharged. The degradation characteristic calculation portion 10 is supplied with the use condition information US and thereby outputs the degradation characteristic data DC which includes storage-based degradation characteristic data DCK (first-class reference degradation characteristic, unshown) when the secondary battery is stored; and charge/discharge-based degradation characteristic data DCE (second-class reference degradation characteristic, unshown) when the secondary battery is charged or discharged, and the sum of both.

Therefore, the use condition information US1, the correction coefficient calculation portion 20 supplies to the degradation characteristic calculation portion 10, also includes storage-based use condition information USK1 (unshown) and charge/discharge-based use condition information USE1 (unshown). The degradation characteristic data DC1, the degradation characteristic calculation portion 10 supplies to the correction coefficient calculation portion 20, also includes storage-based degradation characteristic data DCK1 (unshown), charge/discharge-based degradation characteristic data DCE1 (unshown), and the sum of both.

The arithmetic portion 22 in the correction coefficient calculation portion 20 outputs storage-based correction coefficient $\alpha K$ (first-class correction coefficient, unshown) corresponding to the storage-based use condition information USK1 (unshown), charge/discharge-based use condition information USE1 (unshown), and corresponding charge/discharge-based correction coefficient $\alpha E$ (second-class correction coefficient, unshown), based on the relationship between the degradation point data DA1 and the degradation characteristic data DC1.

The use condition information US2, the degradation characteristic correction portion 30 supplies to the degradation characteristic calculation portion 10, also includes storage-based use condition information USK2 (unshown) and charge/discharge-based use condition information USE2 (unshown). The degradation characteristic data DC2, the degradation characteristic calculation portion 10 supplies to the degradation characteristic correction portion 30, also includes the storage-based degradation characteristic data DCK2 (first-class reference degradation characteristic, unshown), the charge/discharge-based degradation characteristic data DCE2 (second-class reference degradation characteristic, unshown), and the sum of both.

The arithmetic portion 32 in the degradation characteristic correction portion 30 outputs storage-based estimated degradation characteristic data DPK2 (unshown) based on the storage-based degradation characteristic data DCK2 (unshown) and storage-based correction coefficient $\alpha K$ (unshown). The arithmetic portion 32 outputs charge/discharge-based estimated degradation characteristic data DPE2 (unshown) based on the charge/discharge-based degradation characteristic data DCE2 (unshown) and the charge/discharge-based correction coefficient $\alpha E$ (unshown).

The estimated degradation characteristic data DP2 output from the arithmetic portion 32 includes the storage-based estimated degradation characteristic data DPK2, the charge/discharge-based estimated degradation characteristic data DPE2, and the sum of both described above. According to the present embodiment, the degradation prediction device 1 can output the estimated degradation characteristic data DP2 by using the storage-based characteristic degradation model 12K (unshown) during storage of the secondary battery and the charge/discharge-based characteristic degradation model 12E (unshown) during charging or discharging of the secondary battery, thereby further improving the accuracy of the estimated degradation characteristic data DP2.

Third Embodiment

The description below explains the third embodiment. In the following description, parts corresponding to those in the other embodiments described above are given the same reference numerals and the corresponding description may be omitted.

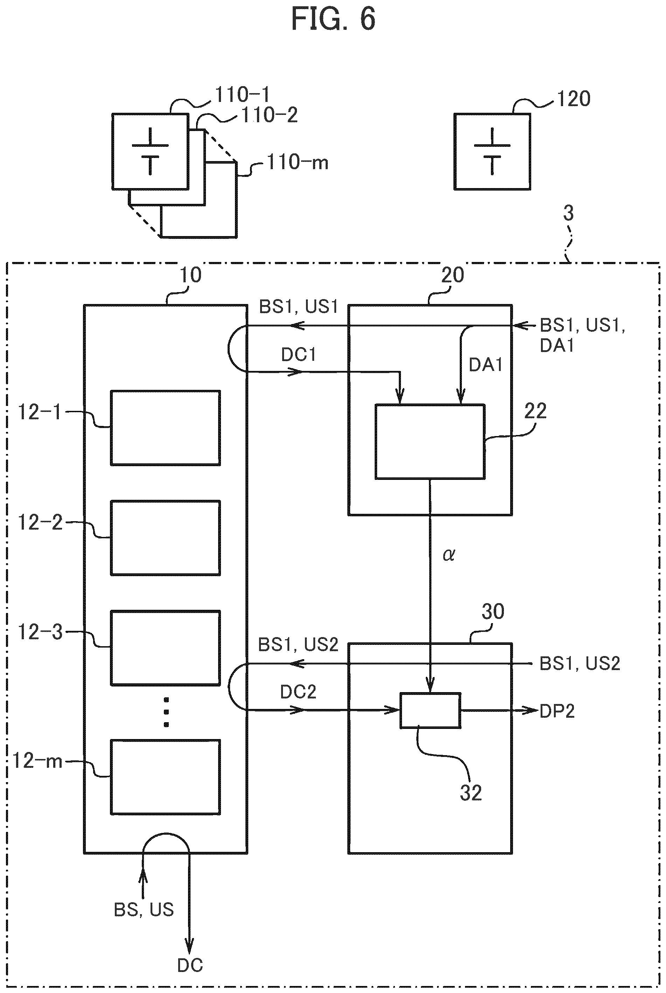

FIG. 6 is a block diagram illustrating a degradation prediction device 3 according to a third embodiment.

As illustrated in FIG. 6, the degradation prediction device 3 includes the degradation characteristic calculation portion 10, the correction coefficient calculation portion 20, and the degradation characteristic correction portion 30. The present embodiment assumes m (plural) types of secondary batteries 110-1 through 110-m (first batteries). The secondary batteries 110-1 to 110-m use known combinations of positive-electrode active material and negative-electrode active material so that the combinations mutually differ and various characteristics are completely analyzed in detail.

The degradation characteristic calculation portion 10 stores characteristic degradation models 12-1 through 12-m corresponding to the secondary batteries 110-1 through 110-m, respectively. Each of the individual characteristic degradation models 12-1 through 12-m is similar to the characteristic degradation model 12 according to the first or second embodiment. The degradation characteristic calculation portion 10 receives battery type information BS specifying any of the secondary batteries 110-1 through 110-m and use condition information US, then outputs degradation characteristic data DC corresponding to the battery type information BS and the use condition information US.

The correction coefficient calculation portion 20 acquires battery type information BS1, use condition information US1, and one or more pieces of degradation point data DA1 concerning the secondary battery 120. The battery type information BS1 specifies the secondary battery 110-g (where $1 \leq g \leq m$) which ensures the same combination of positive-electrode active material and negative-electrode active material as the secondary battery 120.

The correction coefficient calculation portion 20 supplies the degradation characteristic calculation portion 10 with the battery type information BS1 and the use condition information US1 and thereby acquires the corresponding degradation characteristic data DC1. The arithmetic portion 22 included in the correction coefficient calculation portion 20 calculates correction coefficient $\alpha$ based on the degradation characteristic data DC1 and the degradation point data DA1.

The degradation characteristic correction portion 30 acquires the other use condition information US2 different from the above-described use condition information US1 concerning the secondary battery 120 and supplies the degradation characteristic calculation portion 10 with the use condition information US2 and the battery type information BS1. The degradation characteristic correction portion 30 then acquires the degradation characteristic data DC2 corresponding to the battery type information BS1 from the degradation characteristic calculation portion 10. Similar to the first or second embodiment, the arithmetic portion 32 included in the degradation characteristic correction portion 30 calculates the estimated degradation characteristic data DP2 corresponding to the use condition information US2.

Seemingly, it may be possible to calculate the correction coefficient α by using the degradation characteristic data of the secondary batteries 110-1 through 110-m that differ from the secondary battery 120 in the positive/negative-electrode active material. However, the positive/negative-electrode active material to be used varies the degradation characteristics of the secondary battery 120 such as the rate of battery characteristic degradation considering the temperature or battery voltage. The use of such a correction coefficient α troublingly increases a predicted error of the degradation characteristics in the estimated degradation characteristic data DP2 that can be acquired corresponding to the use condition information US2 different from the use condition information US1.

Contrastingly, the present embodiment can calculate correction coefficient α by using the battery type information BS1 to specify the secondary battery 110-g (where 1≤g≤m) that ensures the same combination of positive-electrode active material and negative-electrode active material as the secondary battery 120. The present embodiment can suppress a predicted error of the degradation characteristics also in terms of the estimated degradation characteristic data DP2 in the use condition information US2 different from the use condition information US1.

Fourth Embodiment

The description below explains the fourth embodiment. In the following description, parts corresponding to those in the other embodiments described above are given the same reference numerals and the corresponding description may be omitted.

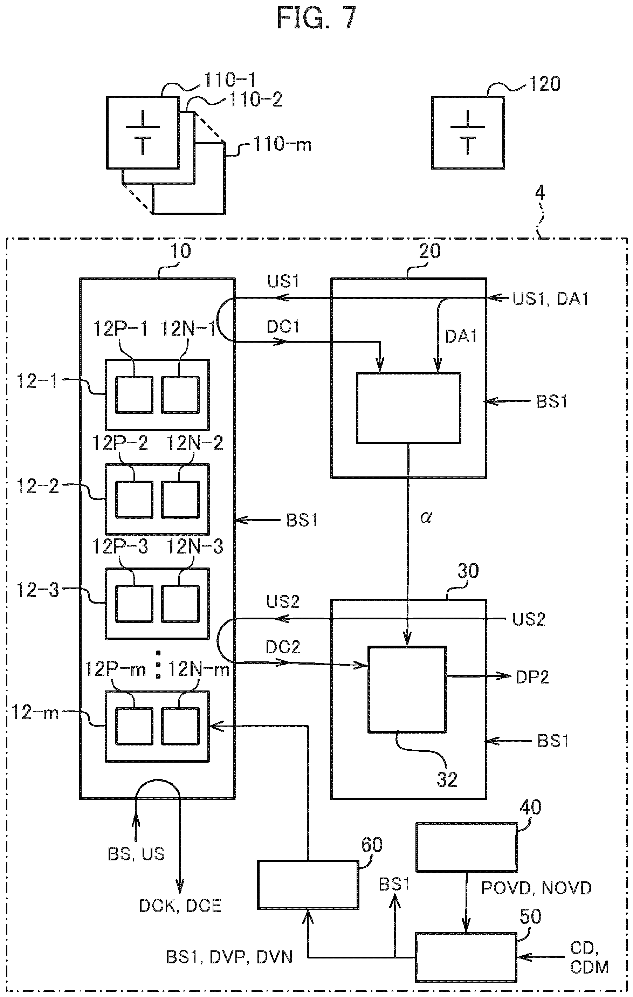

FIG. 7 is a block diagram illustrating a degradation prediction device 4 according to a fourth embodiment;

In FIG. 7, a degradation prediction device 4 includes a degradation characteristic calculation portion 10, the correction coefficient calculation portion 20, the degradation characteristic correction portion 30, a degradation model selection portion 40, a battery characteristics analysis portion 50, and a positive/negative-electrode degradation characteristics correction portion 60. Similar to the third embodiment, the present embodiment also assumes m (plural) types of secondary batteries 110-1 through 110-m.

As above, it is preferable to use the degradation characteristic data DC1 of the secondary batteries 110-1 through 110-m whose positive/negative-electrode active material types are equal to those of the secondary battery 120 to improve the accuracy of the estimated degradation characteristic data DP2 of the secondary battery 120. However, the secondary battery 120 may use an unknown type of positive/negative-electrode active material.

The secondary batteries 120 and 110-g (where 1≤g≤m) may greatly differ in the degradation characteristics for a variety of reasons even if the selected secondary battery 110-g ensures positive/negative-electrode active material types equal to those of the secondary battery 120. For example, the "correspondence relationship among the battery voltage or SOC and the positive and negative electrode potentials" may vary with the "ratio between the amount of positive-electrode active material and the amount of negative-electrode active material on a plane where the positive and negative electrodes are faced" and the "degradation levels of the battery." Accordingly, the secondary batteries 110-g and 120 may differ significantly in the degradation characteristics, especially in a high SOC range of 80% or more and a low SOC range of 20% or less.

The present embodiment provides the following solution to the above problem.

The degradation characteristic calculation portion 10 stores the characteristic degradation models 12-1 through 12-m that include positive-electrode degradation models 12P-1 through 12P-m and negative-electrode degradation models 12N-1 through 12N-m. The characteristic degradation model 12-g (where 1≤g≤m), as a degradation model in the secondary battery 110-g, separately calculates the positive-electrode degradation and the negative-electrode degradation and combines the characteristics of the positive-electrode active material with the characteristics of the negative-electrode active material to generate the degradation characteristic data DC. The technology described in the above-described patent literature 2 can be used to generate the degradation characteristic data DC in this way. Like the third embodiment, the degradation characteristic calculation portion 10 receives the battery type information BS and the use condition information US and then outputs the degradation characteristic data DC by using the characteristic degradation model 12-g corresponding to the battery type information BS.

The battery characteristics analysis portion 50 analyzes reference characteristic data CD of the secondary battery 120 to estimate positive-electrode degradation state parameter value DVP (unshown) and negative-electrode degradation state parameter value DVN (unshown). The reference characteristic data CD defines the relationship between the charge state (discharge amount from a fully charged state) and at least one characteristic value (such as open circuit voltage). In the following description, the "charge state" of the secondary battery 120 signifies the "discharge amount from a fully charged state." The "characteristic value" signifies the "open circuit voltage." The contents of the reference characteristic data CD, namely, the relationship between the "charge state" and the "characteristic value" are assumed to be known according to the measurement results of the secondary battery 120 itself or data sheets provided by a supplier, for example.

The battery characteristics analysis portion 50 estimates the positive-electrode deterioration state parameter value DVP and the negative-electrode deterioration state parameter value DVN which are available as various parameter values, namely, indexes to determine the degree of deterioration of the positive electrode and the negative electrode. For example, the positive-electrode deterioration state parameter value DVP can represent the type of positive-electrode active material, the capacity of the positive electrode, or the range of use of the positive electrode. For example, the negative-electrode deterioration state parameter value DVN can represent the type of negative-electrode active material, the capacity of the negative electrode, or the range of use of the negative electrode.

The positive/negative-electrode degradation characteristics correction portion 60 corrects the positive-electrode degradation models 12P-1 through 12P-m and the negative-electrode degradation models 12N-1 through 12N-m stored in the degradation characteristic calculation portion 10 based on the positive-electrode degradation state parameter value DVP and the negative-electrode degradation state parameter value DVN estimated by the battery characteristics analysis portion 50.

The degradation model selection portion 40 previously stores positive-electrode open-circuit potential characteristic data POVD corresponding to at least one type of positive-electrode active material and negative-electrode open-circuit potential characteristic data NOVD corresponding to one type of negative-electrode active material. The positive-electrode open-circuit potential characteristic data POVD defines the relationship between the charge state and positive-electrode open-circuit potential EP (positive-electrode characteristic value, unshown) concerning a positive electrode that uses a certain positive-electrode active material. The negative-electrode open-circuit potential characteristic data NOVD defines the relationship between the charge state and negative-electrode open-circuit potential EN (negative-electrode characteristic value, unshown) concerning a negative electrode that uses a certain negative-electrode active material.

It is more favorable to previously store the positive-electrode open-circuit potential characteristic data POVD corresponding to all the positive-electrode active materials and the negative-electrode open-circuit potential characteristic data NOVD corresponding to all the negative-electrode active materials used for the secondary batteries 110-1 through 110-m. The degradation model selection portion 40 has the function of selecting any positive-electrode open-circuit potential characteristic data POVD and any negative-electrode open-circuit potential characteristic data NOVD according to the needs.

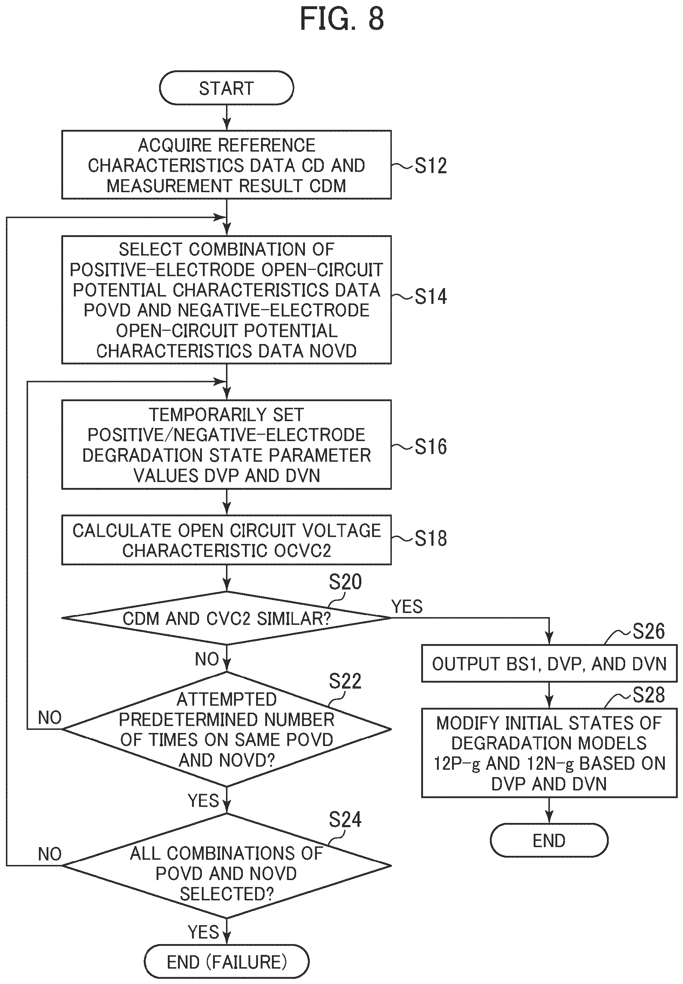

FIG. 8 is a flowchart illustrating the main part of operations on the degradation prediction device 4 according to a fourth embodiment.

When the process proceeds to step S12 in FIG. 8, the battery characteristics analysis portion 50 acquires the reference characteristic data CD of the secondary battery 120 and the corresponding measurement result CDM. The measurement result CDM indicates the measurement result of the charge state SOC2 and the open circuit voltage OCV2 of the secondary battery 120 when the reference characteristic data CD defines the relationship between the charge state SOC2 (unshown) and the open circuit voltage OCV2 (characteristic value, unshown) of the secondary battery 120.

When the process proceeds to step S14, the degradation model selection portion 40 selects a combination including one type of positive-electrode open-circuit potential characteristic data POVD and one type of negative-electrode open-circuit potential characteristic data NOVD. When the process proceeds to step S16, the battery characteristics analysis portion 50 temporarily sets a combination of appropriate values for the positive-electrode degradation state parameter value DVP and the negative-electrode degradation state parameter value DVN.

When the process proceeds to step S18, the battery characteristics analysis portion 50 calculates open circuit voltage characteristic OCVC2 (unshown) based on the positive-electrode degradation state parameter value DVP (unshown), the negative-electrode degradation state parameter value DVN (unshown), the positive-electrode open-circuit potential characteristic data POVD, and the negative open circuit potential characteristic data NOVD. The open circuit voltage characteristic OCVC2 defines the relationship between the charge state SOC2 (unshown) and the open circuit voltage OCV2 (unshown) of the secondary battery 120. For example, the method described in patent literature 2 may calculate the open circuit voltage characteristic OCVC2.

When the process proceeds to step S20, the battery characteristics analysis portion 50 determines whether the measurement result CDM acquired at step S12 approximates the open circuit voltage characteristic OCVC2 (unshown). For example, "to approximate" signifies that, "in the measurement result CDM, an average square error between the open circuit voltage in each charge state and the open circuit voltage in the charge state based on the open circuit voltage characteristic OCVC2 is smaller than or equal to a predetermined value." Various criteria other than the average square error can be used to determine whether to "approximate."

If "No" (not approximate) is determined at step S20, the process proceeds to step S22. The battery characteristics analysis portion 50 determines whether the process at steps S16 through S20 has been attempted a predetermined number of times for the combination of the positive-electrode open-circuit potential characteristic data POVD and the negative-electrode open-circuit potential characteristic data NOVD, selected at step S14.

If "No" (not attempted a predetermined number of times) is determined at step S22, the process returns to step S16. The battery characteristics analysis portion 50 temporarily assumes a combination of values, not yet assumed as a combination of the positive-electrode degradation state parameter value DVP and the negative-electrode degradation state parameter value DVN. The process at steps S16 through S20 is repeated again.

If "Yes" (performed a predetermined number of times) is determined at step S22, the process proceeds to step S24. At step S24, the battery characteristics analysis portion 50 determines whether all combinations of the positive-electrode open-circuit potential characteristic data POVD and the negative-electrode open-circuit potential characteristic data NOVD are already selected at step S14.

If "No" (some combinations are unselected) is determined at step S24, the process returns to step S14. The battery characteristics analysis portion 50 then selects any unselected combination out of all combinations of the positive-electrode open-circuit potential characteristic data POVD and the negative-electrode open-circuit potential characteristic data NOVD. The process at steps S14 through S22 is repeated again.

If "Yes" (all combinations selected) is determined at step S24, the process terminates. This case signifies "an unsuccessful process of estimating the positive-electrode active material and the negative-electrode active material of the secondary battery 120" and the input/output device 987 (see FIG. 3) may notify the user of an associated error message.

If "Yes" is determined at step S20, this signifies that the positive-electrode open-circuit potential characteristic data POVD, the negative-electrode open-circuit potential characteristic data NOVD, the positive-electrode degradation state parameter value DVP, and the negative-electrode degradation state parameter value DVN that are selected (or temporarily assumed) at that time are highly valid. In this case, the process proceeds to step S26 and the battery characteristics analysis portion 50 supplies the degradation characteristic calculation portion 10, the correction coefficient calculation portion 20, the degradation characteristic correction portion 30, and the positive/negative-electrode degradation characteristics correction portion 60 with the battery type information BS1 specifying the secondary battery 110-g (where $1 \leq g \leq m$) corresponding to the positive-electrode active material associated with the positive-electrode open-circuit potential characteristic data POVD and the negative-electrode active material associated with the negative-electrode open-circuit potential characteristic data NOVD. Furthermore, the battery characteristics analysis portion 50 supplies the positive/negative-electrode degradation characteristics correction portion 60 with the positive-electrode degradation state parameter value DVP and the negative-electrode degradation state parameter value DVN.

When the process proceeds to step S28, the degradation characteristic calculation portion 10 selects any one of the characteristic degradation models 12-g (where $1 \leq g \leq m$) based on the battery type information BS1. The positive/negative-electrode degradation characteristics correction portion 60 then corrects the initial value of the negative-electrode degradation model 12N-g in the characteristic degradation model 12-g based on the negative-electrode degradation state parameter value DVN. The positive/negative-electrode degradation characteristics correction portion 60 then corrects the initial value of the positive-electrode degradation model 12P-g in the characteristic degradation model 12-g based on the positive-electrode degradation state parameter value DVP. Then, this routine terminates.

Except for the above, the process of the present embodiment is similar to that described in any of the first through third embodiments.

The correction coefficient calculation portion 20 receives the use condition information US1 and the degradation point data DA1 and then supplies the degradation characteristic calculation portion 10 with the use condition information US1. In response, the degradation characteristic calculation portion 10 supplies the correction coefficient calculation portion 20 with the degradation characteristic data DC1.

In the present embodiment, however, the degradation characteristic calculation portion 10 selects the characteristic degradation model 12-g (where $1 \leq g \leq m$) corresponding to the battery type information BS1 supplied from the battery characteristics analysis portion 50. The above-described process at step S28 corrects the initial values for the negative-electrode degradation model 12N-g and the positive-electrode degradation model 12P-g in the characteristic degradation model 12-g. The arithmetic portion 22 of the correction coefficient calculation portion 20 calculates correction coefficient $\alpha$ based on the degradation characteristic data DC1 and the degradation point data DA1.

The degradation characteristic correction portion 30 receives the use condition information US2 different from the use condition information US1 and then supplies the degradation characteristic calculation portion 10 with the use condition information US2. The degradation characteristic calculation portion 10 supplies the degradation characteristic correction portion 30 with the use condition information US2 and the degradation characteristic data DC2 associated with the battery type information BS1. The degradation characteristic correction portion 30 outputs the estimated degradation characteristic data DP2 associated with the use condition information US2 based on the correction coefficient $\alpha$ and the degradation characteristic data DC2.

Effects of the Embodiments

According to the above-described embodiments, the degradation prediction devices 1, 3, and 4 include the reference degradation characteristic calculation portion (10) that outputs the reference degradation characteristic (DC) as the relationship between the usage amount (t) and the degradation level (Q) corresponding to the input use condition information (US) in terms of the first battery (110); the correction coefficient calculation portion (20) that calculates a correction coefficient ($\alpha$) based on the first reference degradation characteristic (DC1) acquired by supplying the reference degradation characteristic calculation portion (10) with the first use condition information (US1) as one of pieces of the use condition information (US) and at least one piece of degradation point data (DA1) as a combination of the usage amount (t) and the degradation level (Q) in the case of using the second battery (120) under the use condition specified in the first use condition information (US1); and the degradation characteristic correction portion (30) that outputs estimated degradation characteristic data (DP2) as a result of estimating the relationship between the usage amount (t) and the degradation level (Q) of the second battery (120) under the use condition specified in the second use condition information (US2) based on the correction coefficient ($\alpha$) and the second reference degradation characteristic (DC2) acquired by supplying the reference degradation characteristic calculation portion (10) with the second use condition information (US2) as use condition information (US) different from the first use condition information (US1). The reference degradation characteristic (DC) for the first battery (110) can be used to easily acquire the estimated degradation characteristic data (DP2) corresponding to a variety of the second use condition information (US2) on the second battery (120).

More preferably, as is the case with the degradation prediction devices 3 and 4 according to the third and fourth embodiments, the first battery (110-1 through 110-m) and the second battery (120) use the known types of positive-electrode active material and negative-electrode active material; the reference degradation characteristic calculation portion (10) is supplied with the use condition information (US) and the battery type information (BS) specifying a combination of the positive-electrode active material and the negative-electrode active material and then outputs the reference degradation characteristic (DC) corresponding to the battery type information (BS); and the correction coefficient calculation portion (20) calculates a correction coefficient ($\alpha$) based on at least one piece of degradation point data (DA1) and the first reference degradation characteristic (DC1) acquired by providing the reference degradation characteristic calculation portion (10) with the first use condition information (US1) and the battery type information (BS1) corresponding to the second battery (120). It is possible to acquire a reference degradation characteristic (DC) corresponding to the battery type information (BS) and therefore acquire more precise estimated degradation characteristic data (DP2) corresponding to a variety of the second use condition information (US2) about the second battery (120).

More preferably, as is the case with the degradation prediction device 4 according to the fourth embodiment, the reference degradation characteristic calculation portion (10) outputs the reference degradation characteristic (DC) by using characteristic degradation models (12-1 through 12-m) to define the method of calculating the degradation state of the first battery (110) and there are furthermore provided the battery characteristics analysis portion (50) that analyzes types and states of the positive-electrode active material and negative-electrode active material in the second battery (120) by using the positive-electrode open-circuit potential characteristic data (POVD) to define the relationship between the charge state (SOC2) and the characteristic value (OCV2) in terms of at least one characteristic value (OCV2) of the second battery and the relationship between the charge state (SOC2) and the positive-electrode characteristic value (EP) in terms of at least one positive-electrode characteristic value (EP) and the negative-electrode open-circuit potential characteristic data (NOVD) to define the relationship between the charge state (SOC2) and the negative-electrode characteristic value (EN) in terms of at least one negative electrode characteristic value (EN); and the positive/negative-electrode degradation characteristics correction portion (60) that corrects the characteristic degradation models (12-1 through 12-m) by using the analysis results from the characteristics analysis portion (50). It is possible to acquire more precise estimated degradation characteristic data (DP2) based on the types and conditions of the positive-electrode active material and the negative-electrode active material in the second battery (120).

More preferably, as is the case with the second embodiment, the use condition information (US) includes the first-class use condition information (USK) and the second-class use condition information (USE); the reference degradation characteristic (DC) output from the reference degradation characteristic calculation portion (10) includes the first-class reference degradation characteristic (DCK) corresponding to the first-class use condition information (USK) and the second-class reference degradation characteristic (DCE) corresponding to the second-class use condition information (USE); the correction coefficient ($\alpha$) output from the correction coefficient calculation portion (20) includes the first-class correction coefficient ($\alpha$K) corresponding to the first-class use condition information (USK) and the second-class correction coefficient ($\alpha$E) corresponding to the second-class use condition information (USE); and the degradation characteristic correction portion (30) outputs the estimated degradation characteristic data (DP2) based on the first-class reference degradation characteristic (DCK2) acquired corresponding to the second use condition information (US2), the second-class reference degradation characteristic (DCE2) acquired corresponding to the second use condition information (US2), the first-class correction coefficient ($\alpha$K), and the second-class correction coefficient ($\alpha$E). It is possible to acquire more precise estimated degradation characteristic data (DP2) according to the first-class use condition information (USK) and the second-class use condition information (USE).

Modification

The present invention is not limited to the above-described embodiments, and various modifications are available. The above-described embodiments are illustrated for an easy understanding of the present invention and are not necessarily limited to those including all the configurations described. Part of the configuration of one embodiment can be replaced with the configuration of another embodiment, and the configuration of one embodiment can be supplemented with the configuration of another. Part of the configuration of each embodiment can be deleted, supplemented, or replaced with other configurations. The diagrams illustrate control lines or information lines considered necessary for the description and do not necessarily illustrate all control lines or information lines needed for the product. Practically, almost all the configurations may be considered mutually connected. For example, the description below explains possible modifications to the above-described embodiments.

(1) According to the third and fourth embodiments similar to the second embodiment, the use condition information US, US1, and US2 may respectively include the storage-based use condition information USK, USK1, and USK2 (unshown) and the charge/-discharge-based use condition information USE, USE1, and USE2 (unshown), and the characteristic degradation model 12 may include the storage-based characteristic degradation model 12K (unshown) and the charge/discharge-based characteristic degradation model 12E (unshown). In this case, the degradation characteristic calculation portion 10 outputs the degradation characteristic data DC, DC1, and DC2 including the storage-based degradation characteristic data DCK, DCK1, and DCK2 (unshown) and the charge/discharge-based degradation characteristic data DCE, DCE1, and DCE2 (unshown), and the correction coefficient calculation portion 20 outputs the storage-based correction coefficient $\alpha$K (unshown) and the charge/-discharge-based correction coefficient $\alpha$E (unshown). The degradation characteristic correction portion 30 can output the estimated degradation characteristic data DP2 including the storage-based estimated degradation characteristic data DPK2 (unshown) and the charge/discharge-based estimated degradation characteristic data DPE2 (unshown).

(2) According to the above-described fourth embodiment, the characteristic degradation model 12-g (where 1≤g≤m) includes the positive-electrode degradation model 12P-g corresponding to one type of positive-electrode active material and the negative-electrode degradation model 12N-g corresponding to one type of negative-electrode active material. However, the positive-electrode degradation model 12P-g may determine a method of calculating the degradation states based on two or more types of positive-electrode active materials and corresponding composition ratios. Similarly, the negative-electrode degradation model 12N-g may also determine a method of calculating the degradation states based on two or more types of negative-electrode active materials and their composition ratios. The method described in the above-described patent literature 3 may be applied and adopted as a method of generating positive or negative electrode characteristic data when multiple types of positive-electrode active materials or negative-electrode active materials are used.

(3) The various processes performed in the embodiments may be executed by a server computer via a network (unshown) and various data stored in the embodiments may be stored in the server computer.

(4) A general computer can serve as the hardware for the degradation prediction devices 1, 3, and 4 in the embodiments and the flowcharts illustrated in FIGS. 4 and 8 and other programs for executing the various processes described above may be stored in a storage medium (a computer-readable storage medium to record the programs) or distributed via a transmission path.

(5) While the embodiments describe the processes illustrated in FIG. 4 and FIG. 8, along with the other processes described above as software-based processes using a program, all or part of the processes may be replaced with hardware-based processes using an ASIC (Application Specific Integrated Circuit) or an FPGA (Field Programmable Gate Array), for example.

List of Reference Signs

1, 3, 4: degradation prediction device
10: degradation characteristic calculation portion (reference degradation characteristic calculation portion)
12-1 to 12-m: characteristic degradation model
20: correction coefficient calculation portion
30: degradation characteristic correction portion
50: battery characteristics analysis portion
60: positive/negative-electrode degradation characteristics correction portion

110, 110-1 to 110-m: secondary battery (first battery)

120: secondary battery (second battery)

Q: capacity retention rate (degradation level)

t: usage time (usage amount)

α: correction coefficient

BS: battery type information

DC: degradation characteristic data (reference degradation characteristic)

EN: negative-electrode open-circuit potential (negative electrode characteristic value)

EP: positive-electrode open-circuit potential (positive electrode characteristic value)

US: use condition information

αK: storage-based correction coefficient (first-class correction coefficient)

αE: charge/discharge-based correction coefficient (second-class correction coefficient)

BS1: battery type information

DA1: degradation point data

DC1: degradation characteristic data (first reference degradation characteristic)

DC2: degradation characteristic data (second reference degradation characteristic)

DCE, DCE2: charge/discharge-based degradation characteristic data (second-class reference degradation characteristic)

DCK, DCK2: storage-based degradation characteristic data (first-class reference degradation characteristic)

DP2: estimated degradation characteristic data

US1: use condition information (first use condition information)

US2: use condition information (second use condition information)

USE: charge/discharge-based use condition information (second-class use condition information)

USK: storage-based use condition information (first-class use condition information)

DCE2: charge/discharge-based degradation characteristic data (second-class reference degradation characteristic)

DCK2: storage-based degradation characteristic data (first-class reference degradation characteristic)

NOVD: negative-electrode open-circuit potential characteristic data OCV2: open circuit voltage (characteristic value)

POVD: positive-electrode open-circuit potential characteristic data SOC2: charge state

**Claims**

1. A degradation prediction device for secondary battery comprising:

a reference degradation characteristic calculation portion that outputs a reference degradation characteristic as relationship between a usage amount and a degradation level, corresponding to the input use condition information in terms of a first battery;

a correction coefficient calculation portion that calculates a correction coefficient based on a first reference degradation characteristic acquired by supplying the reference degradation characteristic calculation portion with first use condition information as one piece of the use condition information, and based on at least one piece of degradation point data as a combination of the usage amount and the degradation level when a second battery is used under a use condition specified in the first use condition information; and

a degradation characteristic correction portion that outputs estimated degradation characteristic data as a result of estimating the relationship between the usage amount and the degradation level of the second battery under a use condition specified in the second use condition information, based on a second reference degradation characteristic acquired by supplying the reference degradation characteristic calculation portion with a second use condition information as the use condition information different from the first use condition information and based on the correction coefficient.

2. The degradation prediction device for secondary battery according to claim 1,

wherein the first battery and the second battery use a known type of positive-electrode active material and negative-electrode active material;

wherein the reference degradation characteristic calculation portion is supplied with the use condition information and battery type information specifying a combination of the positive-electrode active material and the negative-electrode active material and then outputs the reference degradation characteristic corresponding to the battery type information; and

wherein the correction coefficient calculation portion calculates the correction coefficient based on the first reference degradation characteristic acquired by supplying the reference degradation characteristic calculation portion with the first use condition information and the battery type information corresponding to the second battery and based on at least one piece of the degradation point data.

3. The degradation prediction device for secondary battery according to claim 2,

wherein the reference degradation characteristic calculation portion outputs the reference degradation characteristic by using a characteristic degradation model that defines a method of calculating degradation states of the first battery; and

wherein the degradation prediction device for secondary battery further comprises:

a battery characteristics analysis portion that analyzes types and states of the positive-electrode active material and the negative-electrode active material of the second battery by using positive-electrode open-circuit potential characteristic data to define the relationship between a charge state of at least one characteristic value and the characteristic value in terms of the second battery, and the relationship between the charge state and the positive-electrode characteristic value in terms of at least one positive-electrode characteristic value; and negative-electrode open-circuit potential characteristic data to define the relationship between the charge state and the negative-electrode characteristic value in terms of at least one negative-electrode characteristic value; and

a positive/negative-electrode degradation characteristics correction portion that corrects the characteristic degradation model by using analysis results from the battery characteristics analysis portion.

4. The degradation prediction device for secondary battery according to any one of claims 1 to 3,

wherein the use condition information includes first-class use condition information and second-class use condition information;

wherein the reference degradation characteristic output by the reference degradation characteristic calculation portion includes a first-class reference degradation characteristic corresponding to the first-class use condition information and a second-class reference degradation characteristic corresponding to the second-class use condition information;

wherein the correction coefficient output by the correction coefficient calculation portion includes a first-class correction coefficient corresponding to the first-class use condition information and a second-class correction coefficient corresponding to the second-class use condition information; and

wherein the degradation characteristic correction portion outputs the estimated degradation characteristic data based on the first-class reference degradation characteristic acquired corresponding to the second use condition information, the second-class reference degradation characteristic acquired corresponding to the second use condition information, the first-class correction coefficient, and the second-class correction coefficient.

5. The degradation prediction device for secondary batteries according to claim 1,
   wherein the first battery uses the same electrode active material as that used for the second battery.

6. A degradation prediction method for secondary battery comprising:

acquiring at least one piece of degradation point data, as a combination of a usage amount and a degradation level of a second battery under a first use condition, and first use condition information specifying the first use condition;

calculating a first reference degradation characteristic as a relationship between the usage amount and the degradation level corresponding to the first use condition information in terms of a first battery;

calculating a correction coefficient based on a first reference degradation characteristic acquired based on the first use condition information and at least one piece of degradation point data as a combination of the usage amount and the degradation level of the second battery under the first use condition; and

acquiring estimated degradation characteristic data as a result of estimating a relationship between the usage amount and the degradation level of the second battery under a use condition specified in the second use condition information based on a second reference degradation characteristic acquired corresponding to second use condition information as use condition information different from the first use condition information and based on the correction coefficient.

# FIG. 1

# FIG. 2

# FIG. 3

# FIG. 4

START

ACQUIRE USE CONDITION INFORMATION US1 OF SECONDARY BATTERY 120 AND DEGRADATION POINT DATA DA1 — S2

CALCULATE DEGRADATION CHARACTERISTICS DATA DC1 CORRESPONDING TO USE CONDITION INFORMATION US1 OF SECONDARY BATTERY 110 — S3

COMPARE DEGRADATION CHARACTERISTICS DATA DC1 WITH DEGRADATION POINT DATA DA1 AND CALCULATE CORRECTION COEFFICIENT $\alpha$ — S4

ACQUIRE USE CONDITION INFORMATION US2 — S5

CALCULATE DEGRADATION CHARACTERISTICS DATA DC2 CORRESPONDING TO USE CONDITION INFORMATION US2 OF SECONDARY BATTERY 110 — S6

CORRECT DEGRADATION CHARACTERISTIC DATA DC2 BASED ON CORRECTION COEFFICIENT $\alpha$ AND OUTPUT ESTIMATED DEGRADATION CHARACTERISTICS DATA DP2 — S7

END

# FIG. 5

# FIG. 6

# FIG. 7

# FIG. 8

START

↓

ACQUIRE REFERENCE CHARACTERISTICS DATA CD AND MEASUREMENT RESULT CDM ～S12

↓

SELECT COMBINATION OF POSITIVE-ELECTRODE OPEN-CIRCUIT POTENTIAL CHARACTERISTICS DATA POVD AND NEGATIVE-ELECTRODE OPEN-CIRCUIT POTENTIAL CHARACTERISTICS DATA NOVD ～S14

↓

TEMPORARILY SET POSITIVE/NEGATIVE-ELECTRODE DEGRADATION STATE PARAMETER VALUES DVP AND DVN ～S16

↓

CALCULATE OPEN CIRCUIT VOLTAGE CHARACTERISTIC OCVC2 ～S18

↓

S20 — CDM AND CVC2 SIMILAR? — YES → OUTPUT BS1, DVP, AND DVN ～S26

NO ↓

S22 — ATTEMPTED PREDETERMINED NUMBER OF TIMES ON SAME POVD AND NOVD? — NO

YES ↓

S24 — ALL COMBINATIONS OF POVD AND NOVD SELECTED? — NO

YES ↓

END (FAILURE)

OUTPUT BS1, DVP, AND DVN ～S26

↓

MODIFY INITIAL STATES OF DEGRADATION MODELS 12P-g AND 12N-g BASED ON DVP AND DVN ～S28

↓

END

## INTERNATIONAL SEARCH REPORT

| International application No. |
|---|
| **PCT/JP2023/006376** |

**A.    CLASSIFICATION OF SUBJECT MATTER**

***G01R 31/392***(2019.01)i; ***G01R 31/367***(2019.01)i; ***G01R 31/382***(2019.01)i; ***G01R 31/385***(2019.01)i; ***H01M 10/48***(2006.01)i; ***H02J 7/00***(2006.01)i

FI:    G01R31/392; G01R31/367; G01R31/382; G01R31/385; H01M10/48 P; H02J7/00 Y

According to International Patent Classification (IPC) or to both national classification and IPC

**B.    FIELDS SEARCHED**

Minimum documentation searched (classification system followed by classification symbols)

G01R31/392; G01R31/367; G01R31/382; G01R31/385; H01M10/48; H02J7/00

Documentation searched other than minimum documentation to the extent that such documents are included in the fields searched

Published examined utility model applications of Japan 1922-1996
Published unexamined utility model applications of Japan 1971-2023
Registered utility model specifications of Japan 1996-2023
Published registered utility model applications of Japan 1994-2023

Electronic data base consulted during the international search (name of data base and, where practicable, search terms used)

**C.    DOCUMENTS CONSIDERED TO BE RELEVANT**

| Category* | Citation of document, with indication, where appropriate, of the relevant passages | Relevant to claim No. |
|---|---|---|
| A | WO 2021/192845 A1 (HONDA MOTOR CO LTD) 30 September 2021 (2021-09-30)<br>entire text, all drawings | 1-6 |
| A | JP 2015-59933 A (TOSHIBA CORP) 30 March 2015 (2015-03-30)<br>entire text, all drawings | 1-6 |
| A | JP 2022-18264 A (PANASONIC IP MAN CORP) 27 January 2022 (2022-01-27)<br>entire text, all drawings | 1-6 |
| A | JP 2011-75364 A (SHIN KOBE ELECTRIC MACH CO LTD) 14 April 2011 (2011-04-14)<br>entire text, all drawings | 1-6 |

☐ Further documents are listed in the continuation of Box C.          ☑ See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| **28 April 2023** | **16 May 2023** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | |
| | Telephone No. |

Form PCT/ISA/210 (second sheet) (January 2015)

INTERNATIONAL SEARCH REPORT
Information on patent family members

International application No.

**PCT/JP2023/006376**

| Patent document cited in search report | | | Publication date (day/month/year) | Patent family member(s) | | | Publication date (day/month/year) |
|---|---|---|---|---|---|---|---|
| WO | 2021/192845 | A1 | 30 September 2021 | US | 2022/0413053 | A1 | |
| | | | | entire text, all drawings | | | |
| | | | | CN | 115280578 | A | |
| JP | 2015-59933 | A | 30 March 2015 | (Family: none) | | | |
| JP | 2022-18264 | A | 27 January 2022 | WO | 2022/014151 | A1 | |
| | | | | entire text, all drawings | | | |
| | | | | CN | 115769092 | A | |
| JP | 2011-75364 | A | 14 April 2011 | US | 2011/0196633 | A1 | |
| | | | | entire text, all drawings | | | |
| | | | | WO | 2011/039912 | A1 | |
| | | | | EP | 2490034 | A1 | |
| | | | | CN | 102124360 | A | |
| | | | | KR | 10-2011-0053225 | A | |

Form PCT/ISA/210 (patent family annex) (January 2015)

EP 4 592 695 A1

REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2022018264 A
- JP 2009080093 A

- WO 2014128902 A